# EUROPÄISCHE PATENTANMELDUNG

(11) **EP 2 031 659 A1**
(43) Veröffentlichungstag der Anmeldung: **04.03.2009**
(21) Anmeldenummer: 07017000.6
(22) Anmeldetag: 30.08.2007
(51) Int. Cl.: H01L 31/0224, H01L 31/18, C23C 14/56

(54) **Verfahren zur Erzeugung eines metallischen Rückkontaktes eines Halbleiterbauelements, insbesondere einer Solarzelle**

(71) Anmelder: Applied Materials, Inc., Santa Clara, CA 95054 (US)
(72) Erfinder: Trassl, Roland, 35392 Giessen (DE); Wieder, Stephan, 60385 Frankfurt (DE); Liu, Jian, 63538 Grosskrotzenburg (DE); Henrich, Jürgen, 63694 Limeshain (DE); Rist, Gerhard, 63505 Langenselbold (DE)
(74) Vertreter: Bockhorni & Kollegen

(57) **Zusammenfassung**

Die vorliegende Erfindung betrifft ein Verfahren zur Herstellung eines Rückkontakts (21) eines Halbleiterbauelements, insbesondere einer Solarzelle (20), umfassend eine metallische Schicht (24) auf der Rückseite eines Substrats (22) in einer Vakuumbehandlungskammer und die Verwendung einer Vakuumbehandlungsanlage zur Durchführung dieses Verfahrens. Mit Hilfe dieses Verfahrens und der Verwendung lassen sich insbesondere Solarzellen (20) auf Siliziumbasis auf einfache Weise in kontinuierlicher Prozessführung mit einem Rückkontakt (21) versehen, wobei die Prozessführung besonders effizient und kostengünstig gestaltet werden kann, da keine Handlingsysteme zum Drehen des Substrats (22) erforderlich sind und insbesondere auf Siebdruckschritte verzichtet werden kann.

## Beschreibung

Die vorliegende Erfindung betrifft ein Verfahren zur Herstellung eines Rückkontakts eines Halbleiterbauelements, insbesondere einer Solarzelle, nach dem Oberbegriff von Anspruch 1 und die Verwendung einer Vakuumbehandlungsanlage zur Durchführung dieses Verfahrens nach dem Oberbegriff von Anspruch 16.

Der Photovoltaik wird große Beachtung geschenkt, da ihr schon aus dem Wunsch einer von fossilen Brennstoffen autarken Energieversorgung zukünftig eine noch größere Bedeutung zugemessen wird. Trotz der in letzter Zeit verstärkt untersuchten Dünnschichtsolarzellentechnik ist es nach wie vor die Siliziumtechnologie, auf deren Basis die größten Umsätze erzielt werden. Dies liegt nicht nur daran, dass diese Technologie am ausgereiftesten ist, sondern mit ihr sind bisher auch die effizientesten Solarzellen herstellbar.

Zur Herstellung einer Siliziumsolarzelle werden bisher die folgenden Schritte ausgeführt. In einem ersten Schritt erfolgt eine Schadensbeseitigung und Texturierung des Siliziumwafers. In einem zweiten Schritt wird der Emitter hergestellt durch Einduffision einer Dotierung, beispielsweise des Donators Phosphor, die sich etwa 0,5 µm unter der Oberfläche des Siliziumwafers anlagert und eine Emitterschicht ausbildet. Gleichzeitig mit der Emitterherstellung entsteht SiO₂, was in einem dritten Schritt durch Ätzen wieder beseitigt wird. Danach wird eine SiN:H Antireflexionsschicht aufgebracht, was durch (PE)CVD ((plasma enhanced) chemical vapour deposition)) oder durch einen reaktiven Sputterprozess erfolgt. Die SiN:H-Schicht dient als Passivierungsschicht, indem der Wasserstoff in einem später folgenden Feuerschritt in den Siliziumwafer bzw. die Emitterschicht eindiffundiert und Fehlstellen passiviert. In einem vierten Schritt werden auf der Vorder- und der Rückseite des Wafers durch Siebdruck Kontakte dadurch aufgebracht, dass auf der Vorderseite (die Seite mit der Emitterschicht) eine Silberpaste verwendet wird und auf der Rückseite eine Aluminiumpaste als metallische Schicht mit Aussparungen, in die eine Silberpaste als lötfähige Schicht eingebracht wird. In einem nachfolgenden fünften Schritt wird ein Heizen durchgeführt (Feuerschritt), durch das die Kontakte ausgehärtet werden. Dabei wird auf der Vorderseite das Silber in den Bereichen, in denen es auf der SiN:H-Schicht aufgebracht wurde, durch die SiN:H-Schicht durchgedrückt auf den Siliziumwafer und kontaktiert diesen so. Wie oben schon ausgeführt, erfolgt dadurch gleichzeitig eine Passivierung der frontseitigen Fehlstellen durch Wasserstoffeindiffusion und Anlagerung an die Fehlstellen. Auf der Rückseite bildet sich durch den Feuerschritt ein BSF (back surface field) aus, dass ebenfalls eine Passivierung bewirkt, nämlich der rückseitigen Fehlstellen. Dies geschieht durch in den Siliziumwafer eindiffundierendes Aluminium, wodurch sich ein Al-Si-Eutektikum ausbildet. Schließlich kann eine Kantenisolation zur Vermeidung von Kriechströmen beispielsweise durch Brechen der Wafer bewirkt werden.

Wie vorstehend ausgeführt, besteht der Rückkontakt einer solchen Siliziumsolarzelle in der Regel aus einer metallischen Schicht und umfasst außerdem eventuell eine Barriereschicht und eine lötbare Schicht. Standardmäßig werden die metallischen Schichten der Rückkontakte bisher durch Siebdruck erzeugt. Dadurch ist es aber für großtechnische Anwendungen in Vakuumbehandlungsanlagen mit kontinuierlicher Linienführung, die erst die Wirtschaftlichkeit der Herstellung solcher Solarzellen ermöglichen und bei denen mehrere Substrate gleichzeitig beschichtet werden, erforderlich, jedes einzelne Substrat gesondert mit einem solchen Rückkontakt zu versehen. D.h. dass für jedes einzelne Substrat ein gesonderter Siebdruckschritt durchgeführt werden muss. Dadurch ist der Durchsatz einer solchen Vakuumbehandlungsanlage limitiert. Außerdem sind besondere Handlingsysteme erforderlich, um die Substrate zu drehen, wodurch die Kosten solcher Anlagen erhöht und der Durchsatz weiter gesenkt wird.

Weiterhin ist an den so hergestellten Rückkontakten nachteilig, dass die verwendeten Siebdruckpasten teuer sind und der sich ausbildende Kontakt schlecht ist, da die ausgehärtete Schicht porös ist und so nur ein punktueller Kontakt vorliegt. Es sind für die metallische Schicht etwa 30 µm Schichtdicke notwendig, wodurch sich dünne Wafer durchbiegen können. Diesem Einfluss kommt zunehmend Bedeutung zu, da angestrebt ist, die Waferdicke zu verringern. Die Waferdicke wird dabei in einem Spannungsverhältnis von Kosten und Effizienz ermittelt, wobei sehr dicke Wafer aufgrund des notwendigen Materials teuer sind, sehr dünne Wafer aufgrund der komplizierten Herstellung teuer sind und die Effizienz sich zum einen aus einer genügend großen Schichtdicke zur Absorption des Lichts und zum anderen aus einer so kleinen Schichtdicke bestimmt, dass Verluste infolge Ladungsträgerrekombination gering gehalten werden. Derzeit werden Waferdicken von 200 µm bis 250 µm bevorzugt, wobei sich eine Durchbiegung schon negativ bemerkbar machen würde.

Aufgabe der vorliegenden Erfindung ist es, die Effizienz von Vakuumbehandlungsanlagen bei der Herstellung von Solarzellen mit metallischen Rückkontakten zu erhöhen und dabei insbesondere einen Siebdruckschritt überflüssig zu machen. Die Herstellung soll dabei kostengünstig, insbesondere kommerziell anwendbar, und mit höherem Durchsatz als bisher möglich sein.

Diese Aufgabe wird gelöst durch ein Verfahren nach Anspruch 1 und die Verwendung einer Vakuumbeschichtungsanlage zur Durchführung dieses Verfahrens nach Anspruch 16. Vorteilhafte Weiterbildungen dieses Gegenstands sind in den jeweils abhängigen Ansprüchen enthalten.

Das erfindungsgemäße Verfahren zur Herstellung eines Rückkontakts einer Solarzelle mit einer metallischen Schicht auf der Rückseite eines Substrats zeichnet sich dadurch aus, dass die metallische Schicht mittels Sputtern von einem Target oder durch Aufdampfen in einer in-line-Vakuumbeschichtungsanlage aufgebracht wird, wobei vor oder nach dem Aufbringen der metallischen Schicht mindestens eine weitere Schicht auf der Vorderseite und/oder der Rückseite des Substrates aufgebracht wird.

Für Kleinserien von Silizumsolarzellen wurde zwar schon das Aufbringen metallischer Schichten im Vakuum vorgeschlagen (US 7,071,018 B2). Allerdings nicht in einer in-line-Vakuumbeschichtungsanlage und ausschließlich zur Erzeugung eines BSF (back surface field), wobei zunächst eine metallische Schicht aus Aluminium mittels Aufdampfen oder Aufsputtern aufgebracht wird, die anschließend gesintert und mit einem Gruppe-V-Element dotiert wird. Diese drei Prozessschritte müssen in drei separaten Anlagen durchgeführt werden. Auch diese Beschichtungsmethode ist daher nicht in Vakuumbeschichtungsanlagen mit in-line-Linienführung wirtschaftlich einsetzbar und außerdem muss der eigentliche metallische Rückkontakt weiterhin mittels Siebdruck aufgebracht werden.

Aus der US 7,071,018 B2 ist weiterhin bekannt, dass im Labormaßstab Siliziumsolarzellen verwirklicht worden sind, wobei eine Aluminiumschicht mit einer Schichtdicke von größer gleich 2 µm mittels PVD auf einer dünnen dieelektrischen SiO₂- oder SiN-Schicht aufgebracht wurde. Die SiO₂- oder SiN-Schicht befördert zum einen den Aufbau des BSF und verhindert zum anderen eine Dotierungsdiffusion. Dieses Verfahren ist allerdings nicht geeignet für eine kommerzielle, kostengünstige Produktion, da hierfür Siliziumwafer benötigt werden, die im Floating Zone-Verfahren hergestellt wurden.

Durch das erfindungsgemäße Verfahren ist ein Siebdruckschritt zur Aufbringung der Rückkontakte nicht mehr erforderlich und es erfolgt keine Unterbrechung des Vakuums, so dass eine unerwünschte Oxidbildung und daher der Schritt einer nachträglichen Reinigung vermieden werden.

Wenn die Beschichtungswerkzeuge zum Aufbringen des Rückkontaktes in Bezug auf die Linienführung gegenüberliegend von den Beschichtungswerkzeugen zum Aufbringen der Schichten auf der Vorderseite des Substrats angeordnet sind, sind keine aufwendigen Handlingsysteme zum Drehen des Substrats notwendig. Das Substrat muss daher nicht mehr gewendet werden, sondern kann in von beiden Seiten beschichtet werden. So kann der Großteil des Herstellungsprozesses einer Siliziumsolarzelle prinzipiell in einer In-line-Vakuumbeschichtungsanlage kontinuierlich durchgeführt werden.

Um Abschattungen des Substrates durch den Carrier zu vermeiden ist zweckmäßig vorgesehen, dass das Substrat im Carrier auf im Wesentlichen punktförmigen Auflagen aufliegt.

Bevorzugt wird dabei das Substrat im Wesentlichen horizontal an den Beschichtungswerkzeugen vorbeigeführt. Auf diese Weise können Anlagen, in denen die Beschichtungswerkzeuge in Bezug auf ihre Beschichtungsrichtung vertikal ausgerichtet sind und bei denen ein horizontaler Substrattransport erfolgt, eingesetzt werden, wodurch sich das Handling des Substrates während des Transports vereinfacht, da dieses nun beispielsweise über Transportrollen geführt werden kann.

In einer besonders vorteilhaften Weiterbildung des Verfahrens umfasst die metallische Schicht ein Material aus der Gruppe Aluminium, Silber, Molybdän und/oder Nickel oder eine Mischung einzelner oder mehrerer der vorstehenden Materialien. Diese Metalle weisen aufgrund ihrer elektrischen Leitfähigkeit sehr gute Eigenschaften als Kontakt auf. Bevorzugt soll jedoch Aluminium verwendet werden, da dieses Material kostengünstig ist. Die metallische Schicht soll insbesondere mit einer Dicke von 0,1 µm bis 10 µm, bevorzugt 2 µm abgeschieden werden. Solche dünnen Schichten sind ausreichend, da die Kontaktierung wesentlich besser ist, als bei metallischen Schichten, die im Siebdruckverfahren abgeschieden wurden. Mit diesen dünnen Schichten treten auch keine Probleme hinsichtlich einer Waferdurchbiegung auch bei dünnen Substraten auf.

Vorteilhaft wird zwischen dem Substrat und der metallischen Kontaktschicht eine Passivierungsschicht aus einem Material der Gruppe SiN:H, SiC:H, SiO₂:H oder a-Si:H, bevorzugt aus SiN:H, aufgebracht. Weiterhin kann zweckmäßig eine Barriereschicht, beispielsweise aus WTi vorgesehen sein. Um die Lötfähigkeit der metallischen Kontaktschicht zu verbessern, wird auf diese Schicht vorteilhaft eine lötfähige Schicht aufgebracht. Diese kann eine oder mehrere Lagen aus Materialien der Gruppe Silber (Ag), Nickel (Ni), Nickelvanadiumlegierung (NiV), Nickelchromlegierung (NiCr) und Chrom (Cr) aufweisen. Schichten bzw. Lagen umfassen in diesem Zusammenhang auch Ausbildungen, bei denen keine geschlossene Oberflächenschicht besteht. Beispielsweise kann die lötfähige Schicht auch strukturiert, d.h. nur partiell die Oberfläche bedeckend vorliegen.

Diese zusätzlichen Schichten werden dann jeweils ebenfalls nach dem erfindungsgemäßen Verfahren aufgebracht, wobei sowohl Aufdampfen wie auch Aufsputtern möglich ist, jedoch Aufsputtern bevorzugt wird.

In einer vorteilhaften Weiterbildung erfolgt die Kontaktierung der metallischen Schicht auf der Substratrückseite mit dem Substrat durch partielles Aufschmelzen mittels eines intensiven Laserstrahls, so dass sich ein Laser-fired contact (LFC) ergibt. Dieses Verfahren kann vorteilhaft auch bei Anwesenheit einer Passivierungsschicht auf der Rückseite zwischen dem Substrat und der metallischen Schicht zur Anwendung kommen.

Besonders bevorzugt wird während des Aufbringens mindestens einer Schicht auf der Rückseite des Substrates mindestens eine Schicht auf der Vorderseite des Substrates aufgebracht. Dazu sind in mindestens einer Vakuumbehandlungskammer der Vakuumbehandlungsanlage gegenüberliegende Beschichtungswerkzeuge angeordnet, wobei das Substrat zwischen den Beschichtungswerkzeugen hindurchgeführt wird. Durch das Substrat werden so zwei von einander Kammerbereiche vorgegeben. Dadurch können die räumliche Erstreckung und damit die Kosten einer solchen Vakuumbehandlungsanlage gesenkt und gleichzeitig der Durchsatz erhöht werden, da zwei Schichten gleichzeitig auf einem Substrat aufgebracht werden.

Natürlich muss bei dieser Ausführung sichergestellt sein, dass sich die Abscheidungsprozesse nicht gegenseitig beeinflussen bzw. behindern. So können beispielsweise dann gleichzeitig mehrere Metalle aufgedampft werden, wenn sich die Metalle nicht gegenseitig beeinflussen. Es können auch gleiche Schichten aufgesputtert werden, da sich dann die Prozessgase und die Schichtmaterialien nicht beeinflussen. Nicht jedoch können gleichzeitig Schichten aufgedampft und aufgesputtert werden, da die Prozessgasdrücke mit 10⁻⁴ mbar bzw. 10⁻³ mbar zu unterschiedlich sind.

In Bezug auf die vorliegende Erfindung meint eine "in-line-Prozessführung" also nicht zwingend einen körperlichen Transport des Substrates von einer Vakuumkammer zur nächsten, um verschiedene Schichten aufzubringen, sondern auch ein Durchlaufen einzelner Verfahrensschritte ohne körperlichen Transport des Substrates, vorliegend das gleichzeitige Aufbringung von Schichten auf Vorder- und Rückseite des Substrates. Anders ausgedrückt bedeutet "in-line" auch, dass das Substrat in der Vakuumbehandlungsanlage in eine Vakuumbehandlungskammer transportiert wird, dort in einer Position verharrt und nach erfolgter Beschichtung auf Vorder- und Rückseite die Vakuumkammer und gegebenenfalls auch die Vakuumanlage wieder verlässt. Natürlich kann das Substrat während des Beschichtungsvorganges aber auch transportiert werden.

Der Durchsatz kann zusätzlich erhöht werden, wenn mehrere Substrate, die insbesondere in einem gemeinsamen Carrier angeordnet sind, gleichzeitig mit der metallischen Schicht versehen werden.

Um die Wartung der Anlage zu vereinfachen, kann mindestens ein Beschichtungswerkzeug in einer Vakuumbehandlungskammer schubladenartig bereitgestellt werden. "Schubladenartig" heißt in diesem Zusammenhang, dass nach Herausnahme der betreffenden Schublade keine Unterbrechung des Vakuums der Prozessführung erfolgt, sondern weiterhin Substrate durch die betreffende Vakuumkammer im Vakuum transportiert werden können. Der Transportbereich einer solchen Vakuumbehandlungskammer kann also gegenüber den Einschüben in Bezug auf das Vakuum abgetrennt werden.

Wenn die eine Lage der metallischen Schicht aufgedampft wird, kann das Metall vorteilhaft als Draht durch eine Vakuumdurchführung dem Verdampfer zugeführt werden.

Andererseits kann beim Aufdampfen des Metalls auch folgendermaßen vorgegangen werden: Es werden in zwei nachfolgenden Vakuumbehandlungskammern Verdampfer des Metalls bereitgestellt und das Metall solange in der einen Vakuumbehandlungskammer verdampft bis das Metall in dem darin befindlichen ersten Verdampfer aufgebraucht ist. Wenn das Metall in dem ersten Verdampfer aufgebraucht ist, wird ohne Unterbrechung des Aufdampfens das Metall in der anderen Vakuumbehandlungskammer mit einem zweiten Verdampfer verdampft. Dabei kann insbesondere zugleich der erste Verdampfer, wenn er schubladenartig bereitgestellt ist, gewartet werden und anschließend nachdem der zweite Verdampfer verbraucht ist von dem ersten Verdampfer weiterverdampft werden, und so fort. Dadurch erhöht sich der Durchsatz, da so Metall ohne Unterbrechung des Beschichtungsprozesses verdampft werden kann.

Wenn statt des Aufdampfens ein Aufsputtern erfolgt, kann die metallische Kontaktschicht bevorzugt mit jeweils mindestens einer rotierbaren Kathode aufgesputtert werden. Mit einer solchen rotierbaren Kathode werden dauerhaft wesentlich gleichbleibendere Beschichtungsbedingungen erzielt als mit beispielsweise statischen Planarkathoden. Insbesondere soll dabei die Beschichtung in einem DC-Sputterprozess, wobei auch gepulstes DC-Sputtern oder MF-Sputtern (Mittelfrequenzsputtern von mindestens zwei Targets) möglich ist, und insbesondere dynamisch, d.h. bei gleichzeitigem Substrattransport erfolgen.

In einer vorteilhaften Weiterbildung wird die Anzahl der Kathoden in Abhängigkeit von der Sputterausbeute der Kathoden, der zu erzielenden Dicke der metallischen Schicht und dem zu erzielenden Durchsatz der Vakuumbehandlungsanlage gewählt. D.h. dass bei vorgegebener Schichtdicke, Sputterausbeute und Durchsatz die Kathodenzahl angepasst wird. Natürlich können zugleich auch durch Einstellung der Sputterbedingungen die Sputterausbeute oder/und durch Einstellen der Transportgeschwindigkeit der Durchsatz angepasst werden.

Auch die Barriereschicht und die lötfähige Schicht können mit diesen Aufdampf- oder Aufsputtertechniken aufgebracht werden. Die Passivierungsschicht wird dagegen nur mit Aufsputtern aufgebracht.

Unabhängiger Schutz wird für die Verwendung einer Vakuumbehandlungsanlage mit wenigstens einer Vakuumbehandlungskammer beansprucht, wobei die Vakuumbehandlungsanlage mindestens zwei Beschichtungswerkzeuge umfasst, zur Durchführung des vorbeschriebenen Verfahrens.

Bevorzugt ist es, wenn die Vakuumbehandlungsanlage eine im Wesentlichen horizontale Linienführung aufweist, wobei die Beschichtungsrichtung der Beschichtungswerkzeuge vertikal ausgerichtet ist. Infrage kommen hier beispielsweise Vakuumbeschichtungsanlagen, wie sie in den DE 103 52 143 A1 und DE 103 52 144 A1 beschrieben sind, wobei in diesem Sinne diese Schriften und die darin aufgezeigten Vakuumbehandlungsanlagen vollumfänglich in den Offenbahrungsgehalts der vorliegenden Erfindung mit aufgenommen werden.

Besonders vorteilhaft ist es, wenn die Vakuumbehandlungsanlage wenigstens ein Einschubelement aufweist, das in den Innenraum wenigstens einer Vakuumbehandlungskammer einschiebbar oder aus diesem herausziehbar ist, wobei an den Einschubelementen die Beschichtungswerkzeuge angeordnet sind. Auf diese Weise wird für das Verfahren eine modulartige Anlage bereitgestellt, bei der Standzeiten dadurch minimiert sind, dass die Beschichtungswerkzeuge auf besonders einfache Art ausgetauscht bzw. gewartet werden können. Insbesondere, wenn beispielsweise für die Aufdampfung, wie oben beschrieben, zwei Verdampfer abwechselnd betrieben werden, die in aufeinander folgenden Vakuumbehandlungskammem in solchen Einschubelementen angeordnet sind, lassen sich Standzeiten bezüglich dieses Beschichtungswerkzeuges völlig verhindern.

Entsprechende Vakuumbehandlungsanlagen sind aus der EP 1 698 715 A1 bekannt, wobei in diesem Sinne diese Schrift und die darin aufgezeigten Vakuumbehandlungsanlagen vollumfänglich in den Offenbahrungsgehalts der vorliegenden Erfindung mit aufgenommen werden.

Besonders bevorzugt umfasst wenigstens eine Vakuumbehandlungskammer der Anlage mindestens zwei Beschichtungswerkzeuge, wobei von den Beschichtungswerkzeugen ein erstes auf die Vorderseite und ein zweites auf die Rückseite eines oder mehrere in der Vakuumbehandlungsanlage zu beschichtenden Substrate weist. Auf diese Weise können, wie oben schon beschrieben, die Länge der Anlage und damit deren Kosten und ihr Durchsatz optimiert werden. Vorteilhaft weist dabei mindestens ein Einschubelement zwei Beschichtungswerkzeuge auf, die jeweils auf die Vorder- und die Rückseite der Substrate weisen. So lässt sich die Anlagenlänge noch stärker verkürzen und beide Beschichtungswerkzeuge lassen sich mittels des einen Einschubelements gleichzeitig herausnehmen und warten.

Für ein besonders einfaches Handling kann vorgesehen werden, dass die Vakuumbehandlungsanlage Transportrollen aufweist, auf denen das oder die Substrate oder ein Carrier für mehrere Substrate durch die Vakuumbehandlungsanlage transportiert wird.

Die vorliegende Erfindung wird nun anhand zweier Ausführungsbeispiele im Zusammenhang mit der Zeichnung näher verdeutlicht werden. Dabei zeigen
- Fig. 1: eine in-line-Vakuumbeschichtungsanlage zur Ausführung des erfindungsgemäßen Verfahrens und
- Fig. 2: eine mit dem erfindungsgemäßen Verfahren hergestellte Solarzelle.

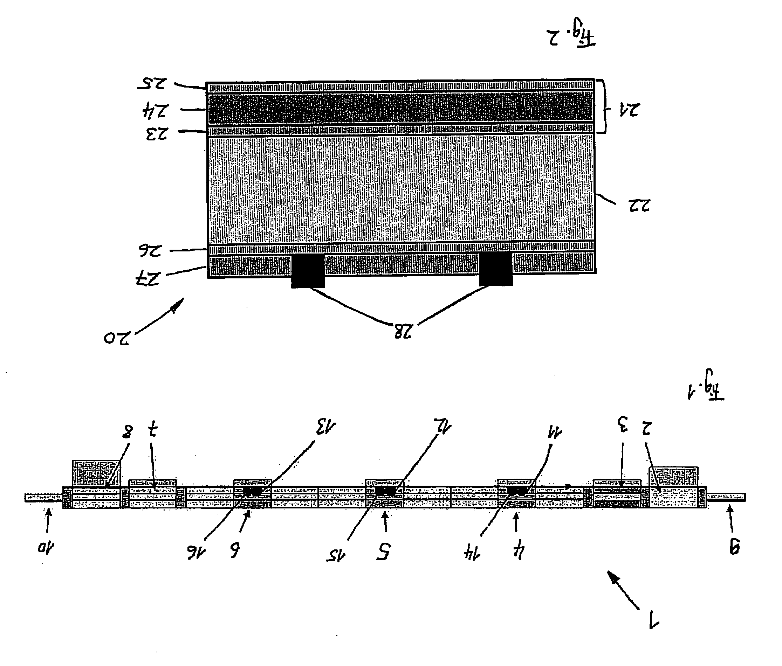

Fig. 1 zeigt rein schematisch eine horizontale In-line-Vakuumbeschichtungsanlage 1. Diese Anlage 1 ist in mehre Vakuumbeschichtungskammern 2, 3, 4, 5, 6, 7, 8 unterteilt sowie einen Be- 9 und einen Entladebereich 10 und weist einen in horizontaler Ebene angeordneten Substrattransport (nicht gezeigt) auf, der über Transportrollen realisiert wird, die mechanisch angetrieben sind, um auf den Transportrollen in Carriern (nicht gezeigt) befindliche Substrate (nicht gezeigt) entlang der Linienführung der Anlage 1 durch die einzelnen nacheinander folgenden Vakuumkammern 2, 3, 4, 5, 6, 7, 8 zu befördern.

Die zur Beschichtung vorgesehenen Vakuumkammern 4, 5, 6 weisen Einschubelemente 11, 12, 13 auf, an denen die einer Kammer zugeordneten Beschichtungswerkzeuge 14, 15, 16 angeordnet sind. Weiterhin sind einer jeden Beschichtungskammer eigene Vakuumpumpen (nicht gezeigt), in der Regel Turbomolekularpumpen, zugeordnet. Als Beschichtungswerkzeuge kommen insbesondere Sputterquellen, wie Sputterkathoden und Magnetrons, aber auch thermische Verdampfer und dergleichen in Betracht. Die Bereitstellung solcher Einschubelemente 11, 12, 13 gestattet eine schnelle Wartung und einen zügigen Austausch der entsprechenden Beschichtungswerkzeuge.

Einzelne oder mehrere in einem Carrier aufgenommene Siliziumsubstrate werden nun auf den Transportrollen sukzessive eingeschleust und kontinuierlich durch die einzelnen Kammern 2, 3, 4, 5, 6, 7, 8 befördert und nachfolgend mit den für eine Solarzelle notwendigen Schichten versehen. Natürlich ist auch ein diskontinuierlicher Transport möglich, wenn die Substrate also nicht während der Beschichtung transportiert werden.

Dabei erfolgt die Beschichtung mit denjenigen Schichten, die sich auf der Vorderseite eines Substrates befinden sollen, durch Beschichtungswerkzeuge, die oberhalb der Linienführung der Substrate angeordnet sind, die also vertikal nach unten weisen. Wenn diese Schichten mittels Sputtern aufgebracht werden, erfolgt diese Beschichtung somit im so genannten "Sputter-Down"-Modus. (Das Anlagenbeispiel gemäß Fig. 1 zeigt hiervon allerdings nur die Herstellung des Rückkontaktes.) Die metallische Schicht für den Rückkontakt der Solarzelle wird wiederum über Beschichtungswerkzeuge 14, 15, 16 aufgebracht, die unterhalb der Linienführung der Substrate angeordnet sind, die also vertikal nach oben weisen. Wenn diese Schichten mittels Sputtern aufgebracht werden, erfolgt diese Beschichtung somit im so genannten "Sputter-Up"-Modus.

Um die Längsausdehnung der Anlage zu verringern und den Durchsatz gleichzeitig zu erhöhen, kann vorgesehen sein, dass in denjenigen Kammern, in denen Beschichtungswerkzeuge für die Beschichtung des Rückkontaktes vorgesehen sind, gleichzeitig auch Beschichtungswerkzeuge für die Aufbringung von Schichten auf der Vorderseite des Substrats angeordnet sind (nicht gezeigt). Allerdings muss, wie gesagt, hier sichergestellt sein, dass sich die beiden Beschichtungsprozesse nicht beeinflussen oder behindern. Beispielsweise könnten die Erzeugung der SiN:H-Schichten auf Vorder- und Rückseite eines Substrates gemeinsam erfolgen. Beide Beschichtungswerkzeuge einer solchen Kammer sind dann jeweils an einem Einschubelement angeordnet und können so ausgetauscht und gewartet werden. Wenn als Beschichtungswerkzeuge wiederum Sputterquellen vorgesehen sind, dann wird folglich in einer Kammer zugleich ein "Sputter-Down"- als auch ein "Sputter-Up"-Prozess durchgeführt. Für einen kontinuierlichen Substrattransport müssen die Beschichtungsraten der beiden Beschichtungswerkzeuge so eingestellt sein, dass sich in Bezug auf die eingestellte Transportgeschwindigkeit der Substrate auf den Transportrollen dynamisch beidseitig die jeweils gewünschte Schichtdicke einstellt. Gleichermaßen sind auch die Beschichtungsraten der Beschichtungswerkzeuge der anderen Kammern so angepasst, dass das Substrat oder die Substrate entlang des gesamten Transportweges innerhalb der Anlage konstant transportiert werden können. Diese Einstellung der Beschichtungsraten ist bei einem diskontinuierlichen Transport nicht nötig.

Der Beschichtungsvorgang eines in die Anlage eingeschleusten Siliziumsubstrates in Bezug auf den Rückkontakt verläuft bei der Herstellung einer Siliziumsolarzelle nun so, dass im "Sputter-Up"-Prozess jeweils eine oder mehrere Rotationskathoden 14, 15, 16 in aufeinander folgenden Kammern 4, 5, 6 eine Passivierungsschicht, die metallische Kontaktschicht, gegebenenfalls eine Barriereschicht (nicht gezeigt) und schließlich zur Verbesserung der Lötfähigkeit des Rückseitenkontakts eine lötbare Schicht auf der Rückseite des Siliziumsubstrates dynamisch aufbringen. Die Anzahl der Rotationskathoden 14, 15, 16 pro Beschichtungskammer hängt dabei ab von der Beschichtungsrate, der gewünschten Schichtdicke und dem gewünschten Durchsatz, also der Transportgeschwindigkeit der Anlage 1.
In einer alternativen Ausführungsform (nicht gezeigt) ist die Anlage im Wesentlichen so wie in der ersten Ausführungsform aufgebaut, wobei das Beschichtungswerkzeug zur Aufbringung der metallischen Schicht und/oder der Barriereschicht und/oder der lötbaren Schicht jeweils keine Sputterquelle sondern ein thermischer Verdampfer ist. Dieser thermische Verdampfer ist in einem Einschubelement angeordnet und sorgt für eine Beschichtung der Substratrückseite. Dabei kann das Metall dem Verdampfer entweder in Drahtform von der Atmosphäre über Vakuumdurchführungen zugeführt werden oder es werden, was bevorzugt ist, jeweils zwei Verdampfer in aufeinander folgenden Kammern in jeweils einem Einschubelement vorgesehen. Ist das Material eines Verdampfers verbraucht, was üblicherweise nach ca. 24 Betriebsstunden erfolgt, wird ein horizontales Ventil über das entsprechende Einschubelement bewegt, das dieses vom Transportvolumen, in dem sich das Substrat bewegt, trennt. Gleichzeitig startet der Beschichtungsprözess mit dem anderen Verdampfer in der benachbarten Kammer. Das durch das Ventil getrennt Einschubelement kann nun belüftet und entnommen werden, so dass der darin angeordnete leere Verdampfer mit neuem Material bestückt werden kann.

Die Passivierungsschicht wird wiederum im "Sputter-Up"-Prozess über eine oder mehrere Rotationskathoden aufgebracht. Auch die Barriereschicht und die lötfähige Schicht können aufgesputtert statt aufgedampft werden, so dass nur die metallische Schicht aufgedampft wird.

Eine mit dem erfindungsgemäßen Verfahren hergestellte Solarzelle 20 weist nach Fig. 2 einen Rückseitenkontakt 21 auf, der als Schichtsystem auf der Substratrückseite eines Siliziumsubstrates 22, aufgebaut ist, und weist die Abfolge Passivierungsschicht 23, metallische Kontaktschicht 24 und lötfähige Schicht 25 auf. Die Passivierungsschicht besteht aus SiN:H, SiC:H, SiO₂:H oder a-Si:H. Die metallische Schicht umfasst ein Material aus der Gruppe Aluminium, Silber, Molybdän und/oder Nickel und besteht bevorzugt aus Aluminium. Bevorzugt besteht die Passivierungsschicht 23 aus SiN:H und die metallische Schicht 24 aus Aluminium. Gegebenenfalls kann zwischen lötfähiger Schicht 25 und metallischer Schicht 24 zusätzlich eine Barriereschicht vorgesehen sein (nicht gezeigt), die beispielsweise aus WTi besteht. Die lötbare Schicht umfasst ein oder mehrere Lagen von Materialien aus der Gruppe Ag, Ni, NiV, NiCr und Cr, beispielsweise eine Lagenabfolge von Ag/NiV und besteht vorzugsweise aus Silber. Nach dem Aufbringen der metallischen Schicht 24 kann ein LFC-Schritt vorgesehen sein, bei dem durch Laser-induziertes Aufschmelzen die metallische Schicht 24 mit dem Substrat 22 punktuell kontaktiert wird und sich so ein Laser-fired contact ausbildet.

Ob die metallische Kontaktschicht 24 aus Aluminium aufgedampft oder aufgesputtert wird, hängt von den konkret erforderlichen Schichtdicken und den Aufbringungsraten der Beschichtungswerkzeuge ab. Wenn beispielsweise LFC-Kontakte (LASER-fired contact) erzeugt werden sollen, werden Schichtdicken von einigen µm benötigt, wozu Aufdampfen angewendet wird. Für dünnere Schichten mit weniger als 1 µm wird dagegen Aufsputtern verwendet. Daher werden bevorzugt auch die Barriereschicht und die lötfähige Schicht 25 aufgesputtert, da diese eine Dicke von weniger als 1 µm aufweisen.

Weiterhin weist die Solarzelle 20 eine Emitterschicht 26, die durch Eindiffusion von Donatoren, beispielsweise Phosphor, erzeugt wurde, eine SiN:H-Passivierungsschicht 27 und balkenartige Frontkontakte 28 aus Silber auf. Die Aufbringung dieser Schichten könnte ebenfalls in die Prozessführung der in-line-Vakuumbeschichtungsanlage 1 integriert werden.

Durch die vorstehenden Ausführungen ist deutlich geworden, dass mit Hilfe des erfindungsgemäßen Verfahrens und der erfindungsgemäßen Verwendung einer Vakuumbehandlungsanlage sich insbesondere Solarzellen auf Siliziumbasis auf einfache Weise mit einer metallischen Schicht für einen Rückseitenkontakt versehen lassen, wobei die Prozessführung besonders effizient (durchsatzstark) und kostengünstig gestaltet werden kann, da auf Siebdruckschritte verzichtet werden kann und so keine Unterbrechung des Vakuums erforderlich ist. Außerdem wird die Waferbruchrate gesenkt, da das Wafer-Handling reduziert wird.

Obwohl die Erfindung nur für eine Solarzelle näher beschrieben wurde, ist klar, dass sie auch für Rückseitenkontakte bei anderen Halbleiterbauelementen vorteilhaft angewendet werden kann.

## Patentansprüche

1. Verfahren zur Herstellung eines Rückkontakts (21) eines Halbleiterbauelements, bevorzugt einer Solarzelle, insbesondere einer siliziumbasierten Solarzelle (20), wobei der Rückkontakt (21) eine metallische Schicht (24) auf der Rückseite eines Substrats (22) umfasst und das Halbleiterbauelement (20) gegebenenfalls weitere Schichten (23, 25, 27, 28) auf der Vorderseite und/oder der Rückseite des Substrats (22) aufweist und die Schichten (23, 24, 25, 27, 28) mittels Beschichtungswerkzeugen (14, 15, 16) aufgebracht werden,
**dadurch gekennzeichnet, dass**
die metallische Schicht (24) mittels Sputtern von einem Target (15) oder durch Aufdampfen in einer in-line-Vakuumbeschichtungsanlage (1) aufgebracht wird und vor oder nach dem Aufbringen der metallischen Schicht (24) mindestens eine weitere Schicht (23, 25, 27, 28) in der in-line-Vakuumbeschichtungsanlage (1) ohne Unterbrechung des Vakuums aufgebracht wird.

2. Verfahren nach Anspruch 1,
**dadurch gekennzeichnet, dass**
die Beschichtungswerkzeuge (14, 15, 16) so bereitgestellt werden, dass die Beschichtungswerkzeuge (14, 15, 16) zum Aufbringen der Schichten (23, 24, 25) auf der Rückseite des Substrates (22) in Bezug auf die Linienführung der Vakuumbeschichtungsanlage (1) gegenüberliegend zu den Beschichtungswerkzeugen zum Aufbringen der Schichten (27, 28) auf der Vorderseite des Substrates (22) angeordnet sind, wobei das Substrat (22) insbesondere auf punktförmigen Auflagen eines Carriers aufliegt, um eine Abschattung des Substrates (22) durch den Carrier weitgehend zu vermeiden.

3. Verfahren nach Anspruch 1 oder 2,
**dadurch gekennzeichnet, dass**
das Substrat (22) im Wesentlichen in einer horizontalen Linienführung an den Beschichtungswerkzeugen (14, 15, 16) vorbeigeführt wird, so dass die Beschichtungsrichtung vertikal verläuft.

4. Verfahren nach einem der Ansprüche 1 bis 3,
**dadurch gekennzeichnet, dass**
die metallische Schicht (24) ein Material oder eine Materialmischung aus der Gruppe Aluminium, Silber, Molybdän und/oder Nickel umfasst und bevorzugt aus Aluminium besteht, wobei die metallische Schicht insbesondere mit einer Dicke von 0,1 µm bis 10 µm, bevorzugt 2 µm abgeschieden wird.

5. Verfahren nach einem der vorherigen Ansprüche ,
**dadurch gekennzeichnet, dass**
vor dem Schritt der Aufbringung der metallischen Schicht (24) eine Passivierungsschicht (23) aus einem Material der Gruppe SiN:H, SiC:H, SiO₂:H oder a-Si:H, bevorzugt aus SiN:H aufgebracht wird.

6. Verfahren nach einem der vorherigen Ansprüche ,
**dadurch gekennzeichnet, dass**
nach dem Aufbringen der metallischen Schicht (24) zur Kontaktierung der metallischen Schicht (24) auf der Substratrückseite mit dem Substrat (22) die metallische Schicht (24) partiell mittels eines intensiven Laserstrahls aufgeschmolzen wird, so dass sich ein Laser-fired contact (LFC) bildet.

7. Verfahren nach einem der vorherigen Ansprüche,
**dadurch gekennzeichnet, dass**
nach dem Schritt der Aufbringung der metallischen Schicht (24) eine Barriereschicht aufgebracht wird, die bevorzugt aus WTi besteht.

8. Verfahren nach Anspruch 5 oder 7,
**dadurch gekennzeichnet, dass**
nach dem Schritt der Aufbringung der metallischen Schicht (24) bzw. nach dem Schritt der Aufbringung der Barriereschicht eine lötbare Schicht (25) aufgebracht wird, die eine oder mehrere Lagen von Materialien aus der Gruppe Ag, Ni, NiV, NiCr oder Cr umfasst.

9. Verfahren nach einem der vorherigen Ansprüche,
**dadurch gekennzeichnet, dass**
in einer Vakuumbehandlungskammer mindestens zwei Schichten aufgebracht werden, wobei während des Aufbringens einer Schicht auf der Rückseite des Substrates (22) eine Schicht auf der Vorderseite des Substrates (22) aufgebracht wird.

10. Verfahren nach einem der vorherigen Ansprüche,
**dadurch gekennzeichnet, dass**
mehrere Substrate, die insbesondere in einem gemeinsamen Carrier angeordnet sind, gleichzeitig mit der Schicht oder den Schichten versehen werden.

11. Verfahren nach einem der vorherigen Ansprüche,
**dadurch gekennzeichnet, dass**
mindestens ein Beschichtungswerkzeug (14, 15, 16) in einer Vakuumbehandlungskammer in einem Einschubelement (11, 12, 13) schubladenartig bereitgestellt wird.

12. Verfahren nach einem der vorherigen Ansprüche,
**dadurch gekennzeichnet, dass**
mindestens zwei Beschichtungswerkzeuge in einer Vakuumbehandlungskammer in einem gemeinsamen Einschubelement schubladenartig bereitgestellt wird, wobei bevorzugt ein erstes Beschichtungswerkzeug auf die Vorderseite und ein zweites auf die Rückseite des Substrates weist.

13. Verfahren nach einem der vorherigen Ansprüche,
**dadurch gekennzeichnet, dass**
mindestens eine der Schichten metallische Schicht (24), Barriereschicht und lötfähige Schicht (25) aufgedampft werden, wobei die entsprechenden Materialien als Draht durch eine Vakuumdurchführung einem Verdampfer zugeführt werden.

14. Verfahren nach einem der Ansprüche 1 bis 12,
**dadurch gekennzeichnet, dass**
mindestens eine der Schichten metallische Schicht (24), Barriereschicht und lötfähige Schicht (25) aufgedampft werden, wobei die entsprechenden Materialien jeweils in zwei nachfolgenden Vakuumbehandlungskammern in einem ersten und einem zweiten Verdampfer verdampfbar sind und jeweils solange in dem ersten Verdampfer verdampft werden bis das Material in dem ersten Verdampfer aufgebraucht ist und die Materialien dann ohne Unterbrechung des Aufdampfens in der jeweils anderen Vakuumbehandlungskammer mit dem zweiten Verdampfer verdampft werden, wenn das jeweilige Material in dem jeweiligen ersten Verdampfer aufgebraucht ist, wobei insbesondere zugleich der jeweilige erste Verdampfer gewartet wird.

15. Verfahren nach einem der vorherigen Ansprüche,
**dadurch gekennzeichnet, dass**
mindestens eine der Schichten (23, 25) mit jeweils mindestens einer rotierbaren Kathode (14, 16), bevorzugt in einem DC-Sputterprozess für metallische Schichten oder dielektrische Schichten von keramischen Sputtertargets oder mittels reaktivem Mittelfrequenzsputtern für dielektrische Schichten von metallischen Sputtertargets, aufgesputtert wird.

16. Verfahren nach Anspruch 15,
**dadurch gekennzeichnet, dass**
die Anzahl der Kathoden in Abhängigkeit von der Sputterausbeute der Kathoden, der zu erzielenden Dicke der Schicht und dem zu erzielenden Durchsatz der Vakuumbehandlungsanlage gewählt wird.

17. Verwendung einer Vakuumbehandlungsanlage (1) mit wenigstens einer Vakuumbehandlungskammer, wobei die Vakuumbehandlungsanlage mindestens zwei Beschichtungswerkzeuge umfasst, zur Durchführung eines Verfahrens nach einem der vorherigen Ansprüche.

18. Verwendung nach Anspruch 17,
**dadurch gekennzeichnet, dass**
die Vakuumbehandlungsanlage (1) eine im Wesentlichen horizontale Linienführung aufweist, wobei die Beschichtungsrichtung vertikal ausgerichtet ist.

19. Verwendung nach einem der Ansprüche 17 oder 18,
**dadurch gekennzeichnet, dass**
die Vakuumbehandlungsanlage (1) mindestens ein Einschubelement (11, 12, 13) aufweist, das in den Innenraum wenigstens einer Vakuumbehandlungskammer (4, 5, 6) einschiebbar und/oder aus diesem herausziehbar ist, wobei an dem Einschubelement (11, 12, 13) mindestens ein Beschichtungswerkzeug (14, 15, 16) angeordnet ist.

20. Verwendung nach einem der Ansprüche 17 bis 19,
**dadurch gekennzeichnet, dass**
wenigstens eine Vakuumbehandlungskammer mindestens zwei Beschichtungswerkzeuge aufweist, wobei ein erstes Beschichtungswerkzeug auf die Vorderseite und ein zweites auf die Rückseite eines oder mehrerer in der Vakuumbehandlungsanlage zu beschichtender Substrate weist.

21. Verwendung nach einem der Ansprüche 17 bis 20,
**dadurch gekennzeichnet, dass**
die Vakuumbehandlungsanlage (1) Transportrollen aufweist, auf denen das oder die Substrate (22) oder ein Carrier für mehrere Substrate durch die Vakuumbehandlungsanlage (1) transportiert werden.
